# EUROPEAN PATENT APPLICATION

(11) **EP 2 469 286 A1**
(43) Date of publication of application: **27.06.2012**
(21) Application number: 11305086.8
(22) Date of filing: 28.01.2011
(51) Int. Cl.: G01P 21/00

(54) **Method for calibrating the accelerometer of a secure element device**

(30) Priority: 22.12.2010 EP 10306487
(71) Applicant: Gemalto SA, 92190 Meudon (FR)
(72) Inventor: GRESSUS, Yvon, 92197, MEUDON (FR); ARNAL, Benoît, 92197, MEUDON (FR)
(74) Representative: Cour, Pierre

(57) **Abstract**

The invention relates to a method for calibrating a set of accelerometers integrated within respective microchips, said accelerometers being connected to microcontrollers of said respective microchips, said accelerometers measuring an acceleration along a first relative direction, said method comprising:
-driving (100) a continuous carrier strip, onto which said microchips are fastened, through a first calibration device, and
-calibrating (114) the accelerometers within said first calibration device by storing offset and sensitivity correction values in a non volatile memory of the microcontroller.

## Description

The invention generally relates to secure element devices integrating nanotechnologies such as accelerometers and to methods for calibrating such devices.

One of the most widespread secure element device is the smart card. A "smart card" is defined as a relatively small, usually pocket-sized card which embeds a microchip for processing information. Smart cards are widely used to store sensitive information such as cryptographic keys or software routines that implement valuable algorithms or know-how. For this purpose, said microchip typically comprises a microcontroller. This microcontroller generally comprises a central processing unit, a random access memory, a ROM memory and an NVM Non Volatile Memory.

Smart cards known from the applicant further comprise micro electro mechanical systems (MEMS) such as accelerometers integrated in their microchip. Such smart cards are for instance used in telecommunication instruments or in GPS (Global Positioning System) to add further functionalities to said smart cards.

In particular, known mobile phones are provided with SIM (Subscriber Identity Module) cards does not include an accelerometer. It is intended to distribute such a SIM card, to allow an upgrade of a mobile phone (which does not originally contain an accelerometer).

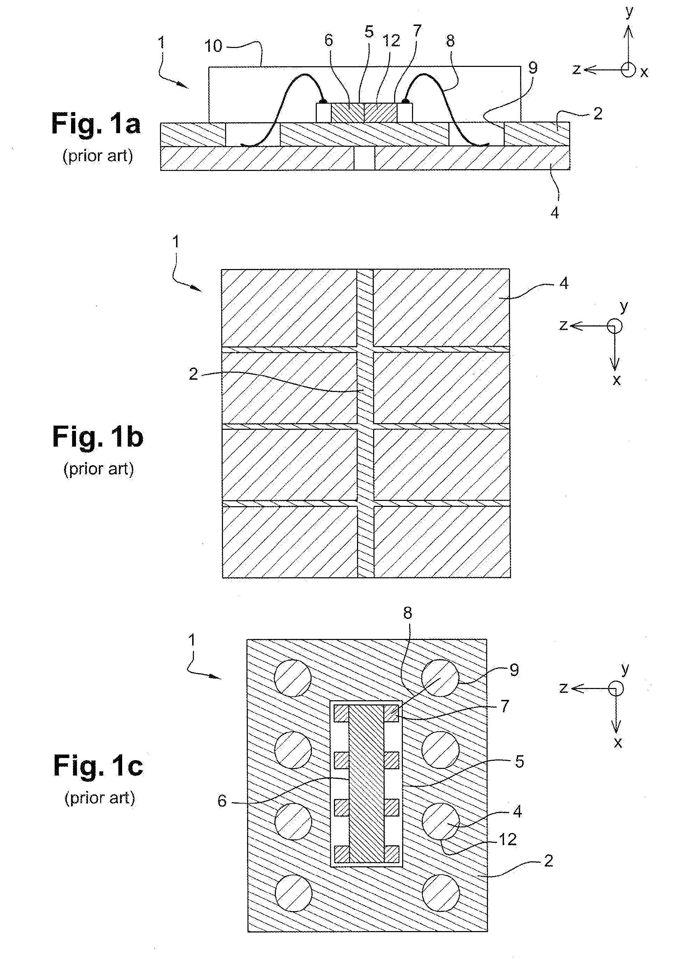

A typical method for manufacturing a smart card comprises a step of forming a smart card module. Figures 1a, 1b, and 1c respectively represent a cross sectional view, a bottom view and a top view of a prior art smart card module 1 at an intermediate stage of its manufacturing.

The smart card module 1 comprises a carrier strip 2. The carrier strip 2 is typically a flexible electrically insulating substrate. For instance, the carrier strip 2 is constituted by an epoxy layer.

Initially, a conductive sheet is fixed onto the rear face of the carrier strip 2 (see figure 1b). The sheet is etched or cut so as to form connection pads 4. These communication pads 4 provide an external communication access to a microchip 5 to be fastened thereto. Here connection pads 4-1 to 4-8 are compliant with the ISO 7816 standard requirements.

The microchip 5 is then fastened onto the front face of the carrier strip 2 (see figure 1 c). The microchip 5 comprises:
- a microcontroller 6,
- a MEMS based accelerometer structure 12 connected to the microcontroller 6. The MEMS structure 12 is sensitive to 3 orthogonal detection or sensitivity axis, and
- contacts 7.

Contacts 7 are electrically linked to connection pads 4 by means of metal wires 8. Metal wires 8 are typically bonded thanks to an « ultrasonic wire bonding» technique, the distal end of each wire being bonded onto the rear face of a respective connection pad 4 through an opening 9 made in substrate 2. This method for connecting the microchip 5 to the connection pads 4 is better known as "wire-bonding" or "chip and wire" technique.

The microchip 5, wires 8 and part of carrier strip 2 are then embedded within a molded plastic casing 10 (the casing 10 is only illustrated on figure 1 a).

The formed smart card module 1 is then punched out of the carrier strip 2 and mounted onto a plastic card to form said smart card.

Industrial processes implementing the above mentioned method for manufacturing smart cards would further comprise a step of calibration of the accelerometer structure to be integrated in the smart cards.

It is currently intended to perform the calibration on the punched out smart card modules 1 as follows. The punched out smart card modules 1 are initially stored in a module container. Then, a robot belonging to a calibration device picks a smart card module 1 from the module container and calibrates its accelerometer structure.

For each detection axis, calibrations determine:
- whether the accelerometer is operable;
- an offset value for this axis; and
- a sensitivity for this axis.

The defective smart card modules identified at that stage are eliminated.

Since the smart card module 1 has three orthogonal sensitivity axis, the calibration device has to carry out three calibrations.

In the above mentioned industrial process, the robot places the smart card module toward a first orientation. The accelerometer structure is thereby submitted to a first relative acceleration during a first calibration stage. Then, the robot turns the smart card module toward a second orientation. The accelerometer structure is thereby submitted to a second relative acceleration during a second calibration stage. Then, the robot turns the smart card module toward a third orientation. The accelerometer structure is thereby submitted to a third relative acceleration during a third calibration stage.

Such a calibration process has several drawbacks. The calibration of the three accelerometers comprises numerous successive steps. The calibration is thereby very time consuming during the manufacturing process.

Moreover, complex robots are needed to rotate the smart card modules toward three specific orientations, and to accurately pick and move the smart card modules. Therefore, the cinematic of the robots is complex and it inexorably implies those robots to be expensive.

Thus, there is a need for a method for calibrating a set of accelerometer structures to overcome at least one of these drawbacks.

For this purpose, the invention proposes a method for calibrating a set of accelerometers integrated within respective microchips, said accelerometers being connected to microcontrollers of said respective microchips, said accelerometers measuring an acceleration along a first relative direction, said method comprising:
- driving a continuous carrier strip, onto which said microchips are fastened, through a first calibration device, and
- calibrating the accelerometers within said first calibration device by accessing their respective microcontrollers.

According to an embodiment the first calibration device comprises means for defining a mechanical reference by maintaining the accelerometers in a position where said first direction is parallel to the direction of the earth gravity field.

According to another embodiment, said accelerometers also measure an acceleration along a second relative direction, said method comprising:
- driving said continuous carrier strip through a second calibration device, the orientation of the strip inside the second calibration device being perpendicular to the orientation of the strip inside the first calibration device;
- calibrating an accelerometer of a microchip within said second calibration device while an accelerometer of another microchip is being calibrated by the first calibration device.

According to a further embodiment, the carrier strip is an initially wound tape, said carrier strip being driven along a strip displacement direction, and said microchips being distributed on said carrier strip along the displacement direction.

According to an embodiment, the calibration of the accelerometers comprises:
- acquiring first measures of said accelerometers when said accelerometers are orientated in a way that said first directions are perpendicular to the direction of the earth gravity field,
- determining the offset of said accelerometers from said first measures,
   and
- memorizing said offset inside said respective microcontrollers.

According to a further embodiment, the calibration of the accelerometers comprises:
- acquiring second measures of said accelerometers, when said accelerometers are orientated in a way that said first directions are parallel to the direction of the earth gravity field,
- determining the sensitivity of said accelerometers from said first and second measures, and
- accessing their respective microcontrollers in order to memorize said sensitivity.

According to another embodiment, the calibration is performed by accessing the microcontrollers through connection pads.

According to an embodiment, said carrier strip is driven and positioned inside the first calibration device using notches formed in said carrier strip.

The invention also relates to a method for manufacturing a set of smart cards, said method comprising:
- providing the carrier strip with a set of connection pads, made of conductive material, designed to provide an external communication access to microchips to be fastened thereto, said microchips integrating a set of respective accelerometers,
- fastening said microchips onto said connection pads,
- calibrating said accelerometers as recited previously,
- forming smart cards by integrating said microchips inside a plastic support.

According to an embodiment, the method further comprises embedding said microchips within respective molded casings to form smart card modules, before the accelerometers of the first set are calibrated.

The invention also relates to a calibration device, comprising:
- means for driving a continuous carrier strip, onto which microchips are fastened, said microchips integrating respective microcontrollers and a set of accelerometers connected to the microcontrollers,
- means for defining a mechanical reference by maintaining the accelerometers in a definite position relative to the earth gravity field and
- means for accessing respective microcontrollers of said microchips fastened to the carrier strip and for calibrating said accelerometers.

The advantage of the present invention will become apparent from the following description of several embodiments with reference to the accompanying drawings, in which :
- Figures 1 a, 1b, and 1c respectively represent a cross sectional view, a bottom view and a top view of a prior art smart card module during its manufacturing process,
- Figure 2 represents a bottom view of an example of carrier strip supporting smart card modules,
- Figure 3 is a schematic illustration of a production line for manufacturing a set of smart cards performing a method according to an embodiment of the invention,
- Figure 4 is an example of a calibration device for the production line illustrated on figure 3, and
- Figure 5 is a schematic cross sectional view of a carrier strip crossing a guiding device in a calibration device;
- Figure 6 is a logical diagram illustrating the method for manufacturing a set of smart cards using the production line illustrated on figure 3.

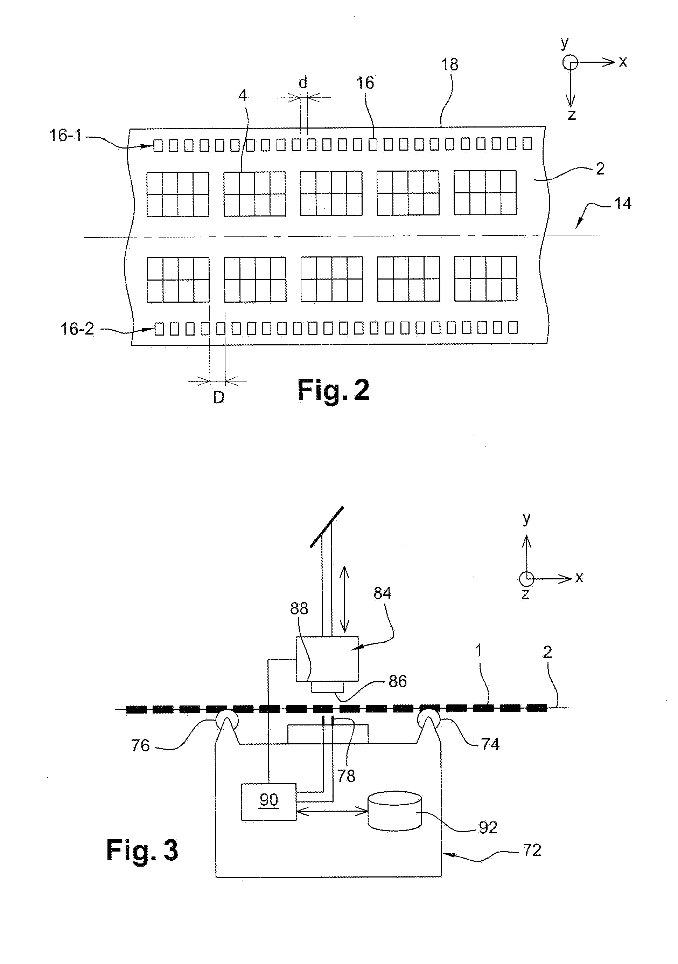

Figures 2 to 4 are all orientated in a same orthogonal system reference R (O; x; y; z).

The invention proposes a method for calibrating an accelerometer structure integrated within respective secure element devices. In this method, the carrier strip acts as a roll conveyer onto which the modules are fastened. The carrier strip is driven through a first calibration device. Therefore, modules are brought directly to the calibration device in order to have first calibration measures performed. Hence, there is no need to pick the modules in a container to proceed to the calibration.

Additionally, once the first calibration device has performed first calibration measures, the carrier strip drives these modules away. Thus, there is no need to place the modules in a container after the calibration.

As a consequence, the cinematic involved is very simple and no expensive robots are required to perform the calibration of the accelerometer structure.

The invention will be disclosed in its application to smart card modules such as illustrated at figures 1a, 1b and 1c. The smart card module 1 is a particular example of secure element devices. The smart card module 1 comprises a flexible electrically insulating carrier strip 2 (for instance an epoxy carrier strip). ISO 7816 compliant connection pads 4 are fastened to the rear face of the carrier strip 2. Other connection pads standards can obviously be used. Some connection pads 4 can be used to perform test operations and can be cut at a later stage of the manufacturing process. The microchip 5 is fastened to the front face of the carrier strip 2. The microchip 5 comprises:
- a microcontroller 6,
- a MEMS based accelerometer structure 12. The accelerometer structure 12 comprises for instance two accelerometers connected to the microcontroller 6. Each accelerometer has a respective sensitivity axis, and
- microcontroller contacts 7.

Contacts 7 are connected to the connection pads 4 by metal wires 8 through openings 9 made in substrate 2. The microchip 5, wires 8 and parts of the carrier strip 2 are embedded inside a molded plastic casing 10.

The accelerometers are for instance sensitive only to single respective directions. The sensitivity of the accelerometer structure can be obtained by combining measures carried out by the accelerometers. The accelerometers are for instance capacitive accelerometers well known from someone skilled in the art and will not be described further. Someone skilled in the art could also design an accelerometer structure based on an accelerometer having a sensitivity to two or three directions, in a manner known per se.

Advantageously, the directions of the respective sensitivities of the accelerometers within structure 12 are orthogonal. Hence, by applying gravity according to an appropriate orientation relative to the smart card module 1, it is possible to measure the three components of any acceleration applied on the smart card module 1.

Figure 2 represents a bottom view of the carrier strip 2. The carrier strip 2 is a rectangular shaped strip extending along a direction 14. The ISO 7816 compliant connection pads 4 are fastened to the rear face of the carrier strip 2. The connection pads 4 are distributed along the direction 14. Connections pads 4 are also distributed in two adjacent rows. Advantageously, connection pads 4 belonging to the same row are separated by a same distance D.

The carrier strip 2 comprises notches 16 for driving the carrier strip 2 by means of toothed driving rollers. The notches 16 are distributed on both edges 18 of the carrier strip 2, along direction 14. Here, notches 16 form two symmetrical rows 16-1 and 16-2 about the middle line of the carrier strip 2 (having direction 14). Advantageously, notches 16 belonging to the same row 16-1 or 16-2 are separated by the same distance d. The carrier strip 2 can thereby be driven without sliding and its driving speed can be thoroughly controlled.

Figure 3 is a schematic illustration of a production line 30 for manufacturing a set of smart card modules. The production line 30 comprises a roll 32 on which the carrier strip 2 (formed as tape) is rolled up. The production line 30 comprises a toothed driving roller 34 for driving the carrier strip 2 along a displacement direction 36. Directions 36 and 14 are parallel to axis x. The production line 30 may further comprise a smart card module assembling unit 38 for assembling smart card modules 1 on the carrier strip 2. The smart card module assembling unit 38 includes:
means 40 for positioning microchips 5 on the front face of the carrier strip 2,
means 44 for connecting wires 8 between contacts 7 and connection pads 4, and
means 46 for molding casings 10 embedding the microchips 5 and wires 8.

The production line 30 further comprises a calibration unit 48 for calibrating the accelerometer structure of the smart card module 1 assembled by the assembling unit 38. The calibration unit 48 is designed for determining the offset and sensitivity for each sensitivity axis of the accelerometer structure 12 of each smart card module 1 and storing said offset and sensitivity within their respective micro controller 6. The calibration is also able to detect the smart card modules 1 including defective accelerometer structures 12.

The offset for an acceleration measured along a specific direction A, is defined as the acceleration measured by the accelerometer structure when the direction of the earth gravity field Dg is perpendicular to the direction A. The sensitivity of the accelerometer structure for this direction A is defined by the difference between the offset and the acceleration it measures when the direction A is parallel to the direction D_{g}.

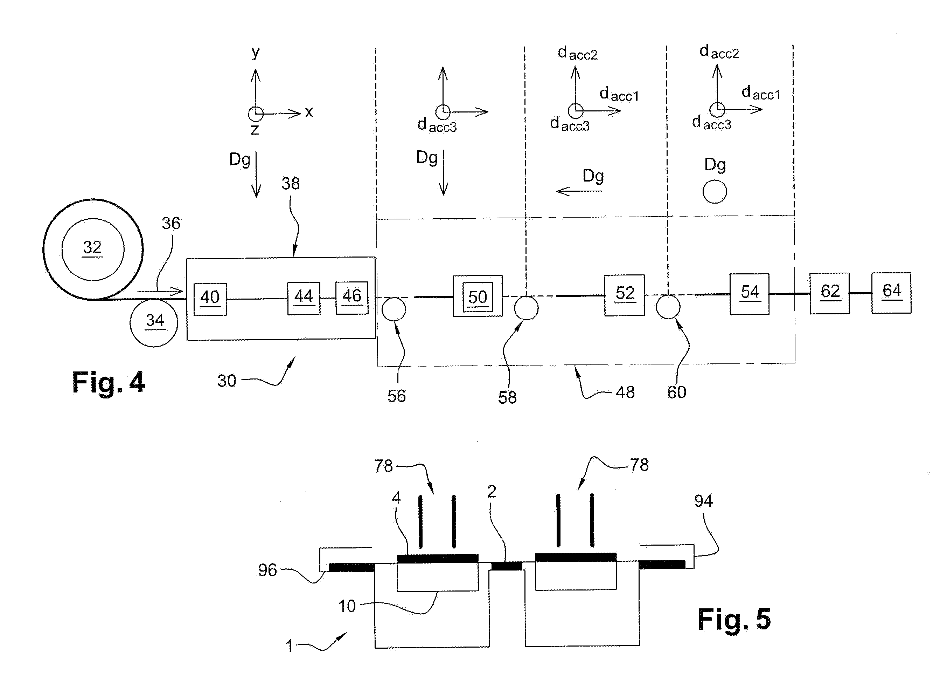

The calibration unit 48 comprises calibration devices 50, 52 and 54. The calibration devices 50, 52 and 54 are further detailed in reference to figure 4.

The calibration unit 48 further comprises sets of rollers 56, 58, and 60 defining the orientation of the carrier strip 2 before it passes through calibration devices 50, 52, and 54 respectively. These rollers 56, 58 and 60 position smart card modules 1 assembled to the carrier strip 2 in specific orientations P1, P2 and P3. The rollers 56, 58 and 60 therefore apply appropriate rotations on the carrier strip 2. The calibration devices 50, 52 and 54 are crossed by smart card modules having respectively the P1, P2 and P3 orientations, to calibrate offsets and sensitivities for the three sensitivity axis of the accelerometer structure. These orientations are illustrated at figure 3 in each section of the calibration unit 48.

The orientation P1 is such that:
the direction d_{acc1} of the first sensitivity axis is perpendicular to the direction of the earth gravity field Dg,
the direction d_{acc2} of the second sensitivity axis is parallel to the direction of Dg, and
the direction d_{acc3} of the third sensitivity axis is perpendicular to the direction of Dg.

The orientation P2 is such that:
the direction d_{acc1} of the first sensitivity axis is parallel to the direction of Dg,
the direction d_{acc2} of the second sensitivity axis is perpendicular to the direction of Dg, and
the direction d_{acc3} of the third sensitivity axis is perpendicular to the direction of Dg.

The orientation P3 is such that:
the direction d_{acc1} of the first sensitivity axis is perpendicular to the direction of Dg,
the direction d_{acc2} of the second sensitivity axis is perpendicular to the direction of Dg, and
the direction d_{acc3} of the third sensitivity axis is parallel to the direction of Dg.

For this purpose:
- rollers 56 are located upstream of the calibration device 50;
- rollers 58 are located downstream of the calibration device 50 and upstream of the calibration device 52;
- rollers 60 are located downstream of the calibration device 52 and upstream of the calibration device 54.

The smartcard modules 1 reaching the exit of the calibration device 54 have a fully calibrated accelerometer structure.

The production line 30 further comprises a device 62 for punching out smart card modules 1 at the output of the calibration unit 48. The smart card modules 1 are thereby separated at that stage. The production line 30 further comprises a device 64 for mounting the smart card modules 1 into a plastic card. The carrier strip 2 can also be rolled at the output of the calibration unit 48. The rolled carrier strip supporting the smart card modules 1 can then be transported to a remote production line where devices 62 and 64 are located.

Figure 4 represents a schematic illustration of a possible embodiment of a calibration device 50 for calibrating the accelerometer structure 12 of the smart card modules 1.

The calibration device 50 comprises a motionless base 72 fastened to the floor. The base 72 comprises toothed driving rollers 74 and 76 for driving the carrier strip 2 by engaging the notches 16.

The calibration devices 50 further comprises means for accessing microcontroller 6 of the smart card modules 1 fastened to the carrier strip 2. Here, these means are probes 78 arranged onto the upper face of the base 72. The probes 78 are designed to press the connection pads 4 of the smart card modules 1.

The calibration device 50 further comprises a movable arm 84 translating along direction y. The arm 84 is movable between:
a raised position, wherein a tip 86, located at the distal end 88 of the arm 84, is separated from the smart card modules 1, and
a pressing position, wherein the tip 86 contacts the casing 10 of a smartcard module 1 in order to hold it accurately in the orientation P1 and in order to create an electrical connection between connection pads 4 and probes 78. In this pressing position, the calibration device 50 defines a mechanical reference position for the smartcard module 1 to be calibrated.

In figure 4, the arm 84 is illustrated in raised position.

The calibration device 50 further comprises a control unit 90 for:
controlling the motion of the arm 84,
controlling rollers 34, 74 and 76 in order to position thoroughly connection pads 4 face to face with probes 78,
applying instructions for having the micro controller 6 of the smartcard module 1 perform a calibration of the accelerometer structure 12 through probes 78.

In this example, the calibration device 50 is described with a movable arm 84 for accurately keeping a smartcard module 1 in its calibration position. Other devices can be designed with a simpler structure, not requiring such a movable arm and just relying on a self positioning of the carrier strip 2 relative to the calibration device 50. For instance, as illustrated at figure 5, the calibration device 50 may be provided with guiding rails 94. Guiding rails 94 guide the transversal edges of the carrier strip 2. The inside lower surface 96 of the guiding rails 94 contacts the lower surface of the carrier strip 2 and forms a mechanical reference according to direction d_{acc2} inside the calibration device 50. Thus, when probes 78 contact the connection pads 4, the smart card module 1 is accurately located inside the calibration device 50. The guiding rails also include a median support for contacting the middle part of the carrier strip 2. The flexion of the carrier strip 2 is thereby prevented when the probes contact the connection pads 4. The guiding rails are advantageously covered by a layer of insulating material, in order to prevent accidental short circuits.

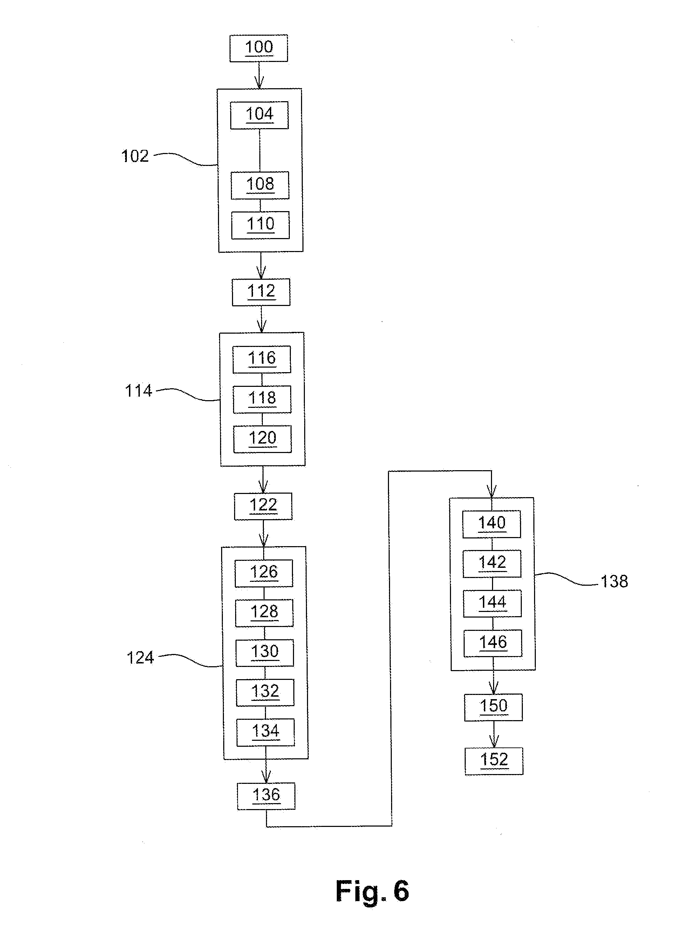

The control unit 90 is linked to a memory 92 containing instructions for executing the method of figure 6.

Calibration devices 52 and 54 are similar to calibration device 50 except that their respective arms translate along directions parallel respectively to directions x and z. Moreover, their respective tips hold smart card modules 1 in the orientations P2 and P3 respectively when they press the casings 10. The respective control units of the calibration devices 50, 52 and 54 are synchronized on the driving of the carrier strip 2. The calibration device 48 thereby performs different calibration steps on the calibration devices 50, 52 and 54 in concurrent operation time.

Figure 6 illustrates a logical diagram illustrating a method for manufacturing a set of smart cards crossing the production line 30.

At step 100, the carrier strip 2 is provided with connection pads 4 and is rotated to form roll 32. Then the roll 32 is set at the beginning of the production line and the driving roller 34 drives the carrier strip 2 along the displacement direction 36 toward the smart card module assembling unit 38.

At step 102, the assembling unit 38 assembles a smart card module 1 on the carrier strip 2. For this purpose, the assembling unit 38 executes the following operations.

During operation 104, the assembling unit 38 places and fastens a microchip 5 on the front face of the carrier strip 2, through means 40.

During operation 108, the assembling unit 38 connects wires 8 between contacts 7 and the connection pads 4 through openings 9, using means 44.

During operation 110, the assembling unit 38 molds a casing 10 embedding the microchip 5 and the wires 8, through means 46.

Thus, once step 102 has been executed, the carrier strip 2 is provided with a smart card module 1.

At step 112, the carrier strip 2 is guided through the set of rollers 56 and is thereby positioned according to the P1 orientation.

At step 114, the smart card module 1 crosses the calibration device 50 for starting calibration of the three sensitivity axis of the accelerometer structure.

During operation 116, the driving rollers 34, 74, and 76 stop driving the carrier strip 2. The carrier strip 2 is stabilized inside the calibration device 50, for instance during 1,5s. Thus, the following measures will not be influenced by the previous motion of the carrier strip. The arm 84 is moved toward its pressing position. Therefore, the tip 86 holds the smart card module 1 in the P1 orientation and connection pads 4 connect to the control unit 90 through probes 78. Thus, the control unit 90 accesses microcontroller 6.

During operation 118, the microcontroller 6 acquires measures for the three sensitivity axis of the accelerometer structure 12.

The smart card module 1 is held in the P1 orientation by the tip 86. Therefore the sensitivity directions d_{acc1} and d_{acc3} are perpendicular to the direction of Dg. Thus, the offsets for the first and third sensitivity directions can be determined directly from the measures acquired during operation 118. The microcontroller 6 stores the measure acquired for the second sensitivity direction.

During operation 120, the offsets for the first and third sensitivity directions are stored in a non volatile memory of the microcontroller 6.

At step 122, the carrier strip 2 is guided through the set of rollers 58 and is thereby positioned in the P2 orientation.

At step 124, the smart card module 1 reaches the calibration device 52.

During operation 126, the driving rollers stop driving the carrier strip 2 and the calibration device 52 holds the smart card 1 in the P2 orientation. The carrier strip 2 is stabilized inside the calibration device 52, for instance during 1,5s.

During operation 128, the microcontroller 6 acquires measures for the first and second sensitivity directions at step 126. Therefore the sensitivity direction d_{acc2} is perpendicular to the direction of Dg. The offset of the second sensitivity direction can thereby be determined.

During operation 130, this offset is stored in a non volatile memory of the microcontroller 6.

During operation 132, the microcontroller 6 determines the sensitivity for the first and second sensitivity directions.

The sensitivity for the first direction can be determined by subtracting the offset measured for this direction (stored during operation 116) and the measure acquired during operation 128. The sensitivity is then calculated based on the known amplitude of the gravity field Dg. A very accurate sensitivity can be determined (for instance with a 20.10⁻³ m/s² resolution).

Similarly, the sensitivity for the second direction can be determined by subtracting the measure acquired for this direction at step 128 and the offset measured for this direction (stored during operation 130). The sensitivity is then calculated based on the known amplitude of the gravity field Dg.

During operation 134, the sensitivities for the first and second directions are stored in a non volatile memory of the microcontroller 6.

At step 136, the carrier strip 2 is guided through the set of rollers 60 and is thereby positioned in the P3 orientation.

At step 138, the smart card module1 reaches the calibration device 54 to complete the calibration for the third sensitivity direction.

During operation 140, the driving rollers stop driving the carrier strip 2 and the calibration device 54 holds the smart card 1 in the P3 orientation. The carrier strip 2 is stabilized inside the calibration device 54, for instance during 1,5s.

During operation 142, the microcontroller 6 acquires measures for the third sensitivity direction. Therefore, the direction d_{acc3} of the third sensitivity axis is parallel to the direction of Dg.

During operation 144, the calibration unit 48 determines the sensitivity for the third direction. The sensitivity for the third direction can be determined by subtracting the offset measured for this direction (stored during operation 116) and the measure acquired for this direction during operation 142. The sensitivity is then calculated based on the known amplitude of the gravity field Dg.

During operation 146, the sensitivity for the third direction is stored in a non volatile memory of the microcontroller 6.

At step 150, the carrier strip 2 reaches the device 62. The smart card modules 1 are punched out, for instance by cutting the carrier strip 2 according to an appropriate pattern. As the smart card modules 1 are driven by the carrier strip 2, their driving is performed by a medium that constitutes one of its final components. An accurate driving can be performed without requiring complex belt conveyors.

At step 152 the smart card modules 1 are mounted into respective plastic cards by the device 64.

The calibration unit 48 advantageously performs different calibration steps in concurrent operation time. When the calibration device 54 performs its calibration steps on one or more smart card modules, the calibration devices 52 and 50 simultaneously perform calibration steps on other smart card modules 1 located upstream on the carrier strip 2. The carrier strip 2 stabilization times in the calibration devices are notably performed concurrently. Thereby, the production line 30 provides a very high throughput. The overall calibration cost of the smart card modules can be significantly reduced.

In a preferred embodiment, the calibration device 50 (as well as calibration devices 52 and 54) is able to calibrate accelerometer structures of several smart card modules 1 simultaneously. For instance, the calibration device 50 calibrates simultaneously accelerometer structures of adjacent smart card modules 1 distributed in the width of the carrier strip 2. Furthermore, the calibration device 50 simultaneously calibrates the accelerometer structures of several successive smart card modules distributed along the direction 14. Thus, the throughput of the production line 30 is high.

In the preferred embodiment, the calibration devices 50, 52 and 54 calibrate sequentially all smart card modules 1 fastened to the carrier strip 2.

Other embodiments than the previous one are possible.

The first, second and third sensitivity directions are not necessarily perpendicular one with each other. In the previous example, each smart card module comprises three sensitivity axis. The invention also applies to a smart card module including fewer sensitivity axis. The accelerometers embedded in the smartcard modules 1 are not necessarily capacitive accelerometers.

In another embodiment, the tips of the calibration devices do not apply a pressure on the casings of smart card modules but apply a pressure directly on the carrier strip in order to avoid damaging the casings.

The example was disclosed using three calibration devices for the calibration of the 3 calibration axis. In order to improve the calibration accuracy, more than three calibration devices can be used. This is not detrimental to the calibration throughputs since this process carries out additional calibration steps in concurrent operation time.

The invention can be applied to calibrate not only linear accelerometers but also gyroscopes intended to measure rotational accelerations. The man skilled in the art is able to design a specific calibration system based on the present teaching and on his common technical knowledge.

The invention also applies to other kinds of smart card modules as the one illustrated before, for instance smart card modules manufactured based on flip-chip techniques. The invention also applies to other kinds of secure element devices.

## Claims

1. Method for calibrating a set of accelerometers integrated within respective microchips (5), said accelerometers being connected to microcontrollers (6) of said respective microchips (5), said accelerometers measuring an acceleration along a first direction, said method comprising:
- driving (100) a continuous carrier strip (2), onto which said microchips (5) are fastened, through a first calibration device (50), and
- calibrating (114) the accelerometers within said first calibration device (50) by accessing their respective microcontrollers (6).

2. Method according to claim 1, wherein the first calibration device (50) comprises means (86) for defining a mechanical reference by maintaining the accelerometers in a position where said first direction is parallel to the direction of the earth gravity field.

3. Method according to claim 1, wherein said accelerometers also measure an acceleration along a second relative direction, said method comprising:
- driving (124) said continuous carrier strip through a second calibration device (52), the orientation of the strip inside the second calibration device being perpendicular to the orientation of the strip inside the first calibration device;
- calibrating (124) an accelerometer of a microchip within said second calibration device (52) while an accelerometer of another microchip is being calibrated by the first calibration device.

4. Method according to claim 1, wherein the carrier strip (2) is an initially wound tape, said carrier strip being driven along a strip displacement direction (36), and said microchips (5) being distributed on said carrier strip along the displacement direction (36).

5. Method according to claim 1, wherein the calibration of the accelerometers comprises:
- acquiring (118) first measures of said accelerometers when said accelerometers are orientated in a way that said first directions are perpendicular to the direction of the earth gravity field,
- determining (120) the offset of said accelerometers from said first measures, and
- memorizing (120) said offset inside said respective microcontrollers (6).

6. Method according to claim 5, wherein the calibration of the accelerometers comprises:
- acquiring (128) second measures of said accelerometers, when said accelerometers are orientated in a way that said first directions are parallel to the direction of the earth gravity field,
- determining (134) the sensitivity of said accelerometers from said first and second measures, and
- accessing (134) their respective microcontrollers (6) in order to memorize said sensitivity.

7. Method according to claim 1, wherein the calibration is performed by accessing the microcontrollers (6) through connection pads (4).

8. Method according to claim 1, wherein said carrier strip (2) is driven and positioned inside the first calibration device (50) using notches (16) formed in said carrier strip (2).

9. Method for manufacturing a set of smart cards, said method comprising:
- providing (100) the carrier strip (2) with a set of connection pads (4), made of conductive material, designed to provide an external communication access to microchips (5) to be fastened thereto, said microchips (5) integrating a set of respective accelerometers,
- fastening (104) said microchips (5) onto said connection pads (4),
- calibrating said accelerometers according to the method of claim 1,
- forming (152) smart cards by integrating said microchips (5) inside a plastic support.

10. Method according to claim 7, wherein the method further comprises embedding said microchips (5) within respective molded casings (10) to form smart card modules (1), before the accelerometers of the first set are calibrated.

11. Calibration device, **characterized in that** it comprises:
- means (34, 74, 76) for driving a continuous carrier strip (2), onto which microchips (5) are fastened, said microchips (5) integrating respective microcontrollers (6) and a set of accelerometers connected to the microcontrollers,
- means for defining a mechanical reference by maintaining the accelerometers in a definite position relative to the earth gravity field and
- means for accessing respective microcontrollers (6) of said microchips (5) fastened to the carrier strip (2) and for calibrating said accelerometers.
